# EUROPÄISCHE PATENTSCHRIFT

(11) **EP 2 481 083 B1**
(45) Veröffentlichungstag und Bekanntmachung des Hinweises auf die Patenterteilung: **10.07.2013**
(21) Anmeldenummer: 10768703.0
(22) Anmeldetag: 20.09.2010
(51) Int. Cl.: H01L 23/00, H01L 23/48, H01L 23/367, H01L 21/60

(54) **VERFAHREN ZUR HERSTELLUNG EINES ELEKTRONISCHEN BAUTEILS UND NACH DIESEM VERFAHREN HERGESTELLTES BAUTEIL**
METHOD FOR FABRICATING AN ELECTRONIC DEVICE AND DEVICE FABRICATED WITH THIS METHOD
PROCÉDÉ DE PRODUCTION D'UN COMPOSANT ÉLECTRONIQUE ET COMPOSANT ÉLECTRONIQUE PRODUIT SELON CE PROCÉDÉ

(30) Priorität: 23.09.2009 DE 102009044086
(43) Veröffentlichungstag der Anmeldung: 01.08.2012
(73) Patentinhaber: United Monolithic Semiconductors GmbH, 89081 Ulm (DE)
(72) Erfinder: BEHAMMER, Dag, 89079 Ulm (DE); STIEGLAUER, Hermann, 89134 Blaustein (DE)
(74) Vertreter: Baur & Weber Patentanwälte
(86) Internationale Anmeldenummer: PCT/EP2010/063773
(87) Internationale Veröffentlichungsnummer: WO 2011/036112

(56) Entgegenhaltungen:
- JP-A- 2 039 569
- US-A- 5 156 998
- US-A- 5 483 092
- US-A1- 2001 028 113

## Beschreibung

Die Erfindung betrifft ein Verfahren zur Herstellung eines elektronischen Bauteils und ein nach einem solchen Verfahren hergestelltes elektronisches Bauteil.

Bei elektronischen Bauteilen mit wenigstens einem Halbleiterbauelement auf einem Halbleitersubstrat muss in dem Halbleiterbauelement im Betrieb anfallende Verlustwärme abgeführt werden. Dies ist insbesondere für Hochfrequenz-Leistungsbauteile von Bedeutung. Das wenigstens eine Bauelement bzw. typischerweise ein eine Mehrzahl von Bauelementen enthaltender monolithisch integrierter Schaltkreis ist auf der Vorderseite des Substrats ausgebildet und die Verlustwärme wird durch das Substrat über dessen Rückseite an eine Wärmesenke abgeführt und beispielsweise über eine Oberfläche eines Gehäuses des Bauteils abgegeben. Die Substrate weisen häufig von der Rückseite zur Vorderseite des Substrats durchgehende Öffnungen auf, welche als elektrisch leitende Durchkontaktierungen von einer flächigen Rückseiten-metallisierung zu Leiterflächen auf der Vorderseite des Substrats dienen. Eine schlechte Wärmeleitung zwischen dem Substrat und der Wärmesenke kann zu Funktionsstörungen oder Ausfällen des Bauteils im Betrieb führen.

Bei der Abfuhr der Verlustwärme von dem die Verlustwärmequelle bildenden Halbleiterbauelement an die Wärmesenke kommt daher der gut wärmeleitenden Verbindung der metallisierten Substrat-Rückseite mit der Wärmesenke besondere Bedeutung zu.

Typischerweise wird auf der Rückseite des Substrats eine Gold(Au)-Schicht abgeschieden, wobei zur festen Verbindung der Au-Schicht mit der Oberfläche des Halbleiter-Substrats üblicherweise eine Haftvermittlerschicht, welche z. B. Ge, Ti, W, Pd oder Cr enthalten kann, aufgebracht und auf dieser die Au-Schicht, vorzugsweise galvanisch, abgeschieden wird. Die dem Substrat abgewandte Oberfläche der Au-Schicht wird mit einer Wärmesenke verlötet, wobei als Lot typischerweise eine eutektische AuSn₄-Legierung, insbesondere in Form eines dünnen Preform-Films eingesetzt wird. Die dem Substrat bzw. dem Preform-Film zuweisende Oberfläche der Wärmesenke weist typischerweise gleichfalls eine Au-Oberfläche auf. Die Lötverbindung zwischen Substrat und Wärmesenke ist insbesondere auf Seiten des Substrats anfällig für das Entstehen von die Wärmeübertragung beeinträchtigenden Hohlräumen. Die Parameter des Lötprozesses sind mit nach Zeit und Temperatur engen Toleranzen einzuhalten, um Fehler in der Lötverbindung gering zu halten.

Die US 7 339 267 B2 beschreibt ein Verfahren zur Herstellung eines auf einem Träger aufgelöteten Halbleiter-Bauelement, auf dessen Rückseite nach einer 3000 nm dicken, galvanisch erzeugten Au-Leitschicht noch eine Barrierenschicht aus 300 nm Ti und 600 nm NiV und nach dieser eine abschließende 500 nm dicke Au-Schicht abgeschieden ist. In einem Löt-Prozess, der zur Verhinderung einer Oxidation in einer Schutzgasatmosphäre ausgeführt wird, wird ein Sn-haltiges Lot-Preframe mit Rückseitenmetallisierung verbunden, wobei die abschließende Au-Schicht mit dem Lot legiert, die Barrierenschicht aber ein Lösen von Au aus der dicken Au-Leitschicht verhindert. In der Barrierenschicht bildet Ti eine haftfeste Verbindung zu der dicken Galvanik-Au-Schicht und NiV verhindert die Ausbreitung des in Au diffusionsfreudigen Ti. Die Barrierenschicht und die abschließende Au-Schicht werden auch in Durchgangslöchern und an Kanten der Au-Leitschicht abgeschieden.

Eine Rückseitenmetallisierung mit einer Barrierenschicht und einer abschließenden Au-Schicht ist für ein lichtemittierendes Halbleiter-Bauelement aus der DE 196 32 635 A1 bekannt, wobei unterhalb des aktiven Halbleiterbereichs in der abschließenden Au-Schicht ein Fenster ausgespart ist, um an dieser Stelle eine mechanische Verbindung beim Lösten zu unterbinden und mechanische Spannungen zu verringern. In der EP 1 850 400 A1 ist ein lichtemittierendes Bauelement mit verlöteter Rückseitenmetallisierung beschrieben, bei welchem die Rückseitenmetallisierung nach einer Leitschicht eine Ti-Barrierenschicht und eine zur Verlötung dienende Au-Hilfsschicht enthält.

Die US 5 027 189 zeigt einen Halbleiteraufbau auf einem GaAs-Substrat mit Durchgangslöchern, in welchen auch Schichten einer Rückseitenmetallisierung abgeschieden sind. Diese umfassen insbesondere eine dicke Au-Leitschicht und nach dieser eine Barrierenschicht aus Ni. Eine abschließende Au-Schicht, welche zum Verlöten dient, ist selektiv nur außerhalb der Durchgangslöcher abgeschieden, so dass beim Lötprozess eine Benetzung und Legierung des Lotes nur außerhalb der Durchgangslöcher auf der abschließenden Au-Schicht stattfindet.

Bei einem aus der US 2003/0020174 A1 bekannten Halbleiterbauelement wird ein Durchgangsloch von der aktiven Bauelementseite her mit einer Ti-Au-Au-Schichtenfolge metallisiert, bevor das Substrat gedünnt und eine Rückseitenmetallisierung aufgebracht wird, welche eine Barrierenschicht zur Verbindung des Vordringens von Lot in das Durchgangsloch enthält.

Im Konferenzbeitrag "How to Process the Backside of GaAs Wafers" von Varmazis et al. in Semiconductor International, 1. Dez. 2000 sind Probleme und Verfahren der Rückseitenmetallisierung von Halbleitersubstraten mit Durchgangskontaktierungen diskutiert. Um ein zu mechanischen Spannungen führendes Verfüllen der Durchgangskontaktierungen mit dem geschmolzenen AuSn-Lot zu verhindern, wird vorgeschlagen, die Oberfläche der Au-Schicht Rückseitenmetallisierung mit einer zusätzlichen Schicht aus Ti, Ni oder Cr zu überdecken und diese zusätzliche Schicht mittels einer Photomaske und einem Ätzprozess auf der ebenen Fläche der Rückseiten-metallisierung außerhalb der Durchgangskontaktierungen wieder zu entfernen und die Gold-Oberfläche der Au-Schicht wieder freizulegen. Nach der Entfernung der Photomaske ist in den Durchgangslöchern die Oberfläche durch die zusätzliche Schicht gegeben, welche oxidiert und schlecht mit dem AuSn-Lot benetzbar ist.

Der vorliegenden Erfindung liegt die Aufgabe zugrunde, ein Verfahren zur Herstellung eines Bauteils mit einer über eine Au-Schicht und ein AuSn-Lot gebildeten Lötverbindung zwischen einem metallisierte Durchgangslöcher aufweisenden Substrat und einer Wärmesenke sowie ein nach einem solchen Verfahren hergestelltes Bauteil anzugeben.

In der US 2001/0028 113 A1 sind verschiedene Verfahren zur Herstellung eines Halbleiterbauelements mit via-holes beschrieben, welche jeweils das Einfließen von AuSn-Lot in die via-holes verhindern sollen, indem ein für die Verlötung vorgesehener Au-Film nur auf der Substrat-Rückseite, nicht aber an Wänden der via-holes abgeschieden wird. Neben Verfahrensbeispiel mit flächenselektiver Erzeugung des Au-Films auf der Rückseite und einer eine Benetzung mit dem Au-Sn-Lot verhindernden Ni-Schicht in den via-holes ist eine Verfahrensvariante beschrieben, bei welcher die via-holes mit so steilen Flanken erzeugt werden, dass sich ein nach der Ni-Schicht anisotrop abgeschiedener Au-Film nur am Eingang der via-holes, nicht aber tiefer an deren Seitenwänden niederschlägt.

Erfindungsgemäße Lösungen sind in den unabhängigen Ansprüchen beschrieben. Die abhängigen Ansprüche enthalten vorteilhafte Ausgestaltungen der Erfindung.

Wesentlich ist zum einen die Unterteilung der Rückseitenmetallisierung in eine erste und eine zweite Au-Schicht und eine zwischen diesen liegende Zwischenschicht, welche aus einem von Au und Sn verschiedenen Material besteht und eine Diffusionsbarriere für Sn in Au bildet und hierdurch das Vordringen von Sn aus dem geschmolzenen AuSn-Lot in die erste Au-Schicht verhindert. Die Zwischenschicht, welche nachfolgend auch als Barrierenschicht bezeichnet ist, besteht hierfür vorteilhafterweise zumindest teilweise aus einem Material, welches sich während des Lötprozesses nicht in der flüssigen AuSn-Phase, welche sich an der Stelle der zweiten Au-Schicht bildet, auflöst. Eine Löslichkeit des Materials der Zwischenschicht in der flüssigen AuSu-Phase in einem Umfang, der für die Barrierenfunktion vernachlässigbar gering ist und die Dichtigkeit der Zwischenschicht gegen das Ausbreiten der flüssigen AuSu-Phase in die erste Au-Schicht nicht beeinträchtigt, sei als einer Unlöslichkeit im Sinne der Barrierenfunktion gleichwertig verstanden. Die Zwischenschicht kann insbesondere zumindest überwiegender Menge eine oder mehrere der Materialien aus Ti, W, Mo, Ta auch in Form chemischen Verbindungen dieser Materialien wie z. B. TiN enthalten und besteht vorteilhafterweise zumindest überwiegend, vorzugsweise vollständig aus Ti und/oder TiN. Die zweite Au-Schicht ist vorteilhafterweise wesentlich dünner als die erste Au-Schicht, so dass die erste Au-Schicht weitgehend die mechanischen, thermischen und elektrischen Eigenschaften der Rückseitenmetallisierung bestimmt. Die dünnere zweite Au-Schicht wird beim Lötprozess vorteilhafterweise vollständig und gleichmäßig in eine Au-Sn-Legierung umgewandelt. Die Schichtdicke der zweiten Au-Schicht beträgt vorteilhafterweise nicht mehr als 160 nm, insbesondere nicht mehr als 120 nm, vorzugsweise nicht mehr als 90 nm.

Unter Legierung seien hierbei und im folgenden auch als Sonderfall die nichteutektischen intermetallischen Phasen von Metallgemischen verstanden. Unter Diffusion sei sowohl die Diffusion eines Stoffes durch einen Festkörper als auch die Vermischung von Stoffen in flüssigen Phasen verstanden. Die chemischen Elemente sind, soweit nicht explizit anders angegeben, durch ihre chemischen Abkürzungen aus dem Periodensystem bezeichnet.

Die Zwischenschicht, die nachfolgend auch als Barrierenschicht bezeichnet ist, kann vorteilhafterweise zusätzlich die Diffusion von Verunreinigungen aus der dickeren, vorzugsweise galvanisch abgeschiedenen ersten Au-Schicht, insbesondere auch die Diffusion aus einer Haftvermittlerschicht, welche z. B. Ge enthält, zwischen der ersten Au-Schicht und dem Halbleiter-Substrat, in die zweite Au-Schicht und zu deren Oberfläche in der ebenen Anlagefläche der Rückseitenmetallisierung zu dem AuSn-Lot-Preform vermindern und durch solche Diffusionen bewirkte Benetzungsstörungen verringern. Die Zwischenschicht besitzt hierfür vorteilhafterweise einen für solche Verunreinigungen höheren Diffusionswiderstand als die erste Au-Schicht.

Wesentlich ist ferner, dass bei den von der Erfindung betroffenen Substraten mit Durchgangs-Löchern, an deren Seitenwänden die Rückseitenmetallisierung abgeschieden ist, die zweite Au-Schicht anisotrop mit an den Seitenwänden der Durchgangslöcher im Mittel geringerer Schichtdicke als an der ebenen Rückseitenfläche, an welcher das Lot-Preform angelegt wird, abgeschieden ist. Die verringerte Schichtdicke an den Seitenwänden der Durchgangslöcher kann vorteilhafterweise so gering gewählt werden, dass bei einer Behandlung des metallisierten Substrats mit erhöhter Temperatur Material aus der Zwischenschicht in einem solchen Maß an die Oberfläche der in den Durchgangslöchern dünnen zweiten Au-Schicht diffundiert, das dieses Material dort die Benetzung der Au-Oberfläche mit dem AuSn-Lot so stark herabsetzt, dass kein geschmolzenes Lot in die Durchgangslöcher eindringt. Die mittlere Schichtdicke der zweiten Au-Schicht an den Seitenwänden der Durchgangslöcher in deren der Vorderseite zugewandter Hälfte beträgt vorteilhafterweise weniger als 40 nm. Vorteilhafterweise ist die Schichtdicke der zweiten Au-Schicht geringer als die Schichtdicke der Zwischenschicht. Die Behandlung des metallisierten Substrats bei höherer Temperatur ist vorteilhafterweise durch Lötprozess, insbesondere durch den Anfang des Lötprozesses, bei welchem das Substrat auf die Schmelztemperatur des AuSn-Lots erhitzt wird, gegeben. Es kann auch ein anderer oder gesonderter Temperaturbehandlungsschritt für diese gewünschte Diffusion durchgeführt werden. Als Material der Zwischenschicht ist dabei Ti, welches aufgrund einer im Temperaturbereich des Lötvorgangs stark negativen Bildungsenthalpie der Oxidation an der Au-Oberfläche schnell oxidiert und als Mittel zur Verhinderung einer Lotbenetzung an sich bekannt ist, besonders vorteilhaft. Der Lötprozess erfolgt hierfür vorteilhafterweise in sauerstoffhaltiger Atmosphäre. Es kann auch ein dem Lötprozess vorgeschalteter Oxidationsschritt, dann vorzugsweise als Diffusions- und Oxidationsschritt, vorgesehen sein. Ti zeigt vorteilhafterweise zwischen 250°C und 320°C und somit im Temperaturbereich des Lötprozesses eine starke Zunahme der bei niedrigeren Temperaturen vernachlässigbaren Diffusion durch die zweite Au-Schicht. Andere Stoffe mit im Temperaturbereich des Lötprozesses starker Diffusion durch die zweite Au-Schicht und, ggf. nach Oxidation, benetzungsvermindernder Wirkung können für diesen Effekt gleichfalls in der Zwischenschicht eingesetzt werden. An der ebenen Anlagefläche der Rückseitenmetallisierung tritt aufgrund der dort größeren Dicke der zweiten Au-Schicht und aufgrund der schnellen Benetzung durch den unmittelbar anliegenden AuSn-Lot-Preform-Film der Einfluss der Ti-Diffusion nicht oder nicht in nennenswertem Umfang in Erscheinung, so dass dort eine im wesentlichen vollständige flächige Lötverbindung und damit eine gute Wärmeleitung vom Substrat zur Wärmesenke entsteht. Eine photolithografische Strukturierung einzelner Schichten ist nicht erforderlich.

Die Erfindung ermöglicht vorteilhafterweise Lötverbindungen zwischen der Wärmesenke und der Rückseitenmetallisierung des Substrats mit störungsarmer guter Wärmeleitung vom Substrat zur Wärmesenke. Der Löt-Prozess ist einfach zu steuern und erlaubt eine größere Variation der Prozessparameter als ohne die Zwischenschicht.

In einer Weiterbildung kann die Zwischenschicht aus mehreren Materialien zusammengesetzt sein, welche auch verschiedene Teilschichten der Zwischenschicht bilden können, wobei
- ein erstes Zwischenschichtmaterial sich nicht in der flüssigen AuSn-Phase auflöst und ein Ausbreiten der während des Lötprozesses an der Stelle der zweiten Au-Schicht auftretenden flüssigen AuSn-Phase in die erste Au-Schicht verhindert und hierfür in ausreichender Dicke von vorteilhafterweise wenigstens 100 nm, insbesondere wenigstens 150 nm, vorzugsweise wenigstens 200 nm in der Zwischenschicht vorliegt und
- ein zweites Zwischenschichtmaterial bei einer Behandlung bei erhöhter Temperatur, insbesondere dem Lötprozess selbst, an die Oberfläche der zweiten Au-Schicht an den Seitenwänden der Durchgangslöcher diffundiert und deren Benetzbarkeit durch das geschmolzene Lot herabsetzt.

Beispielsweise kann die Zwischenschicht aus einer TiN/Ti-Schichtenfolge aufgebaut sein, in welcher die TiN-Teilschicht zuverlässig die Ausbreitung der flüssigen AuSn-Phase in die erste Au-Schicht verhindert und aus der Ti.-Teilschicht Material durch die feste zweite Au-Schicht an deren Oberfläche diffundiert und dort die Benetzbarkeit verringert. Die Ti-Teilschicht kann in diesem Fall auch dünner ausgeführt sein und, insbesondere an Unebenheiten, auch Lücken aufweisen, da die Barrierenfunktion durch die TiN-Schicht erfüllt wird.

Die Erfindung ist nachfolgend anhand bevorzugter Beispiele unter Bezugnahme auf die Abbildungen noch eingehend veranschaulicht. Dabei zeigt:
- Fig. 1: eine Darstellung miteinander zu verlötender Komponenten,
- Fig. 2: die fehlerfrei verlöteten Komponenten,
- Fig. 3: typische Fehlersituationen,
- Fig. 4: eine erfindungsgemäße Rückseitenmetallisierung,
- Fig. 5: einen Lötvorgang mit der Metallisierung nach Fig. 4.

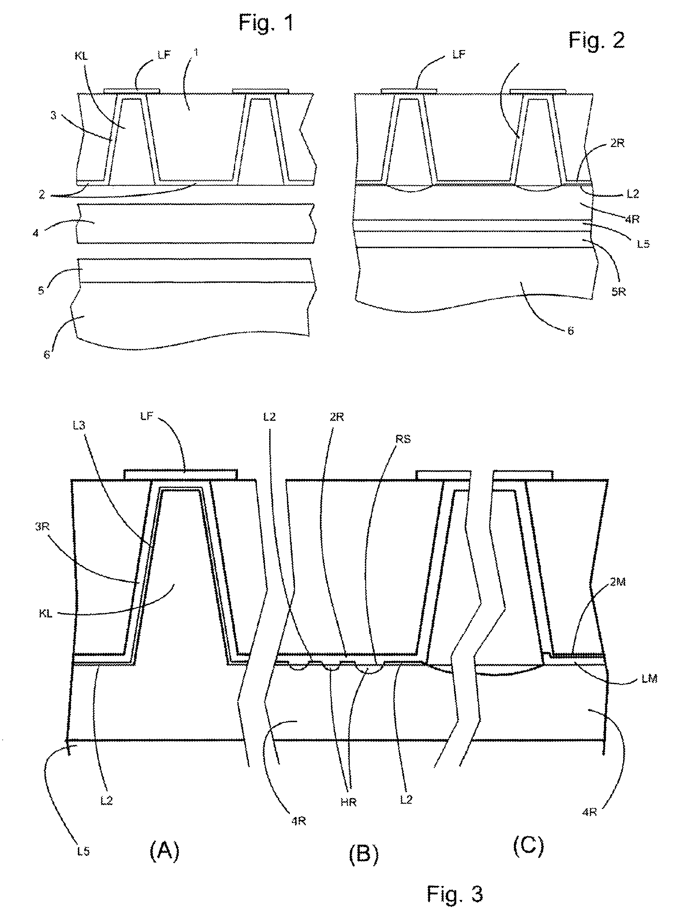

In Fig. 1 ist als Schnittdarstellung schematisch die relative Anordnung eines Substrats 1 mit Rückseitenmetallisierung 2, eines Lot-Preforms 4 und eines Modulträgers 6 als Wärmesenke dargestellt. Das gedünnte Halbleiter-Substrat 1 trägt auf seiner Vorderseite VS, in welcher auch ein oder mehrere HalbleiterBauelemente als Quellen für im Betrieb anfallende Verlustwärme angeordnet sein können, Leiterflächen LF, beispielsweise zur Kontaktierung von Bauelementanschlüssen und/oder zur Verbindung mehrerer Bauelemente untereinander. Auf der Rückseite RS des Substrats 1 ist eine Rückseitenmetallisierung abgeschieden, welche sich als Durchkontaktierung 3 auch entlang der Seitenwände von Kontaktlöchern KL, welche zwischen der Rückseite RS und der Vorderseite VS des Substrats durchgehend verlaufen, bis zu den Leiterflächen LF auf der Vorderseite VS erstreckt. Die Metallisierungen 2 und 3 werden typischerweise gemeinsam abgeschieden.

Die dem Lot-Preform 4 bzw. dem die Wärmesenke bildenden Modulträger 6 zuweisende Oberfläche der Rückseitenmetallisierung 2 ist typischerweise durch eine Gold(Au)-Oberfläche gebildet. In der Regel besteht die Rückseitenmetallisierung 2, welche beispielsweise eine Dicke von ca. 4.000 nm besitzt, weitgehend vollständig aus Au, welches vorzugsweise galvanisch abgeschieden ist. Auf der Halbleiteroberfläche der Rückseite RS des Substrats und den Wänden der durchgehenden Öffnungen KL wird in der Regel eine Haftvermittlerschicht und eine Au-Startschicht als sogenannte seed-Layer abgeschieden, welche die Haftung der Au-Schicht auf dem Halbleitermaterial verbessert und die Wachstumsschicht für die galvanische Verstärkung bildet.

Das Lot-Preform ist typischerweise durch einen ebenen Film gebildet, welcher aus einer eutektischen Au-Sn-Legierung mit 80 % Au und 20 % Sn besteht. Das Lot-Preform sei als in sich materialhomogen angenommen.

Auf der dem Lot-Preform 4 bzw. dem Halbleiter-Substrat 1 zuweisenden Fläche des Modulträgers 6 ist eine weitere Metallisierungsschicht abgeschieden, welche wiederum zumindest überwiegend aus Gold besteht und eine dem Lot-Preform zuweisende Au-Oberfläche besitzt.

Zur Herstellung einer gut wärmeleitenden gelöteten Verbindung zwischen dem Substrat 1 und dem Modulträger 6 zur Ableitung von im Substrat 1 im Betrieb des wenigstens einen in dem Substrat integrierten Halbleiter-Bauelements anfallenden Verlustwärme zu dem Modulträger 6 als Wärmesenke werden das Substrat mit der Rückseitenmetallisierung 2 und der Modulträger 6 mit der weiteren Au-Schicht 5 an die gegenüber liegenden Seiten des Lot-Preforms 4 angelegt und auf eine zum Schmelzen des Au-Sn-Lotes des Preform 4 ausreichenden Temperatur erhitzt. Die Schmelztemperatur eines eutektischen Au-Sn-Lotes liegt bei 278° C. Das Lot kann neben Au-Sn als Hauptbestandteil noch Zusätze oder Verunreinigungen enthalten.

Au und Sn sind gemäß dem AuSn-Phasendiagramm bei einem eutektischen Au₄Sn-Gewichtsverhältnis bereits bei relativ niedrigen Temperaturen in flüssiger Phase gut ineinander lösbar, so dass beim Schmelzen der Oberflächen des Lot-Preforms sich Gold aus der Rückseitenmetallisierung 2 in dem Lot und Sn aus dem Lot in Au der Rückseitenmetallisierung 2 löst. Es entstehen schichtparallele Übergangsbereiche L2, in welchen eine Au-Sn-Legierung mit hypereutektischem, d. h. mehr als 80 % Anteil von Au vorliegt. Von der ursprünglichen Au-Schicht der Rückseitenmetallisierung 2 verbleibt nach Abschluss des Lötvorgangs eine Schicht 2R aus unlegiertem Au, welche bei fehlerfreiem Lötvorgang in der Regel noch die überwiegende Dicke der ursprünglichen Schichtdicke der Rückseitenmetallisierung 2 aufweist. Im Bereich der Durchkontaktierungen KL durch das Substrat dringt idealerweise das Lot nicht in diese Kontaktlöcher ein. Zwischen dem Lot-Preform 4 und der weiteren Au-Schicht 5 auf dem Modulträger 6 bildet sich gleichfalls eine Legierungsschicht L5 mit hypereutektischem Au-Anteil aus. Die in der Zusammensetzung im wesentlichen unveränderte verbleibende Lotschicht ist mit 4R, die im wesentlichen unlegiert bleibende Restschicht der Au-Schicht 5 ist mit 5R bezeichnet.

Gegenüber dem in Fig. 2 dargestellten idealen Ergebnis einer fehlerfreien Lötung können beim realen Lötprozess verschiedene Fehler auftreten, von welchen Fig. 3 drei wesentliche Ausbildungen zeigt.

In Fig. 3 (A) ist eine Situation dargestellt, bei welcher während des Lötprozesses flüssiges Lot auch in das Kontaktloch KL der Durchgangskontaktierung eingedrungen ist und dieses im wesentlichen ausfüllt. Analog zu der Legierungsschicht L2 zwischen der Au-Restschicht 2R an der Rückseite des Substrats bildet sich an der Au-Oberfläche der Metallisierungsschicht 3 an den Seitenwänden der Durchkontaktierung KL eine Legierungsschicht L3 zwischen einer Au-Restschicht 3R und dem die Durchkontaktierung ausfüllenden Lot 4K. Durch die Verfüllung des Kontaktloches mit Lot können im Betrieb thermomechanische Spannungen auftreten, welche das Substrat oder Teile hiervon zerstören und das Bauteil unbrauchbar machen können.

Fig. 3 (B) zeigt eine Fehlerform, bei welcher die Au-Oberfläche der Rückseitenmetallisierung 2 beim Schmelzen des Lotes des Lot-Preforms 4 in Flächenabschnitten NB vom geschmolzenen Lot unbenetzt bleibt und Gaseinschlüsse HR entstehen, welche zu bleibenden Hohlräumen nach Erstarren des Lotes führen. Ein metallischer Übergang zwischen dem Substrat und dem Modulträger tritt an der Rückseitenmetallisierung des Substrats dann nur an den mit Lot benetzten Flächenbereichen, an welchen sich die Legierungsschicht L2 zwischen der Au-Restschicht 2R und dem Lot ausbildet, auf, wogegen die nicht benetzten Oberflächenbereiche NB praktisch nicht zur Wärmeableitung beitragen. Es kann lokal oder im gesamten Schaltkreis zu einer unzulässig starken Erwärmung im Betrieb des Halbleiterbauteils kommen, wodurch Funktionalität und Lebensdauer des Schaltkreises auf dem Substrat reduziert sein können.

In Fig. 3 (C) ist eine Fehlersituation dargestellt, bei welcher die sich während des Lötvorgangs zwischen dem Lot des Lot-Preforms 4 und der Au-Schicht 2 der Rückseitenmetallisierung ausbildende Legierungsschicht LM eine große Tiefe innerhalb der ursprünglichen Au-Schicht 2 annimmt und nahe oder ganz bis zum Substrat reichen kann. In Fig. 3 (C) ist noch eine dünne Au-Restschicht 2M der ursprünglichen Au-Schicht 2 dargestellt, wogegen die Legierungsschicht LM mit hypereutektischem Au-Anteil bis nahe an die Rückseite RS des Substrates reicht. Da Au-Sn-Phasen mit hypereutektischem Au-Anteil in der Regel wesentlich spröder sind als die reinen Metalle oder die eutektische Legierung der AuSn-Schicht 4 kann es durch die spröden Eigenschaften der Legierungsschicht LM zu Ablösungen der Rückseitenmetallisierung von der Rückseite des Substrates kommen, wodurch wiederum der Wärmeübergang von wenigstens einem Bauelement als Verlustwärmequelle auf der Vorderseite des Substrats zu dem Modulträger 6 als Wärmesenke behindert wird und einer Überhitzung des Substrats bzw. des integrierten Bauelements oder Schaltkreises droht.

Die Fehlersituation nach Fig. 3 (A) kann beispielsweise durch eine im einleitend genannten Stand der Technik erwähnte Maßnahme mit einer benetzungsmindernden selektiven Beschichtung der Au-Oberfläche der Metallisierungsschicht 3 oder durch flächenselektive Abscheidung der zweiten Au-Schicht 25 nm auf der planen Rückseitenfläche der Zwischenschicht erfolgen. Die Bildung von Hohlräumen HR nach Fig. 3 (B) durch nicht benetzende Oberflächenbereiche NB kann teilweise verringert werden durch höhere Temperaturen während des Lötprozesses. Höhere Temperaturen während des Lötprozesses verstärken aber nachteiligerweise das Auftreten von Fehlersituationen nach Fig. 3 (C), da mit zunehmender Temperatur, insbesondere bei Temperaturen oberhalb 300°C gemäß dem AuSn-Phasendiagramm die gegenseitige Löslichkeit von Au und Sn in nicht-eutektischem Mischungsverhältnis stark zunimmt.

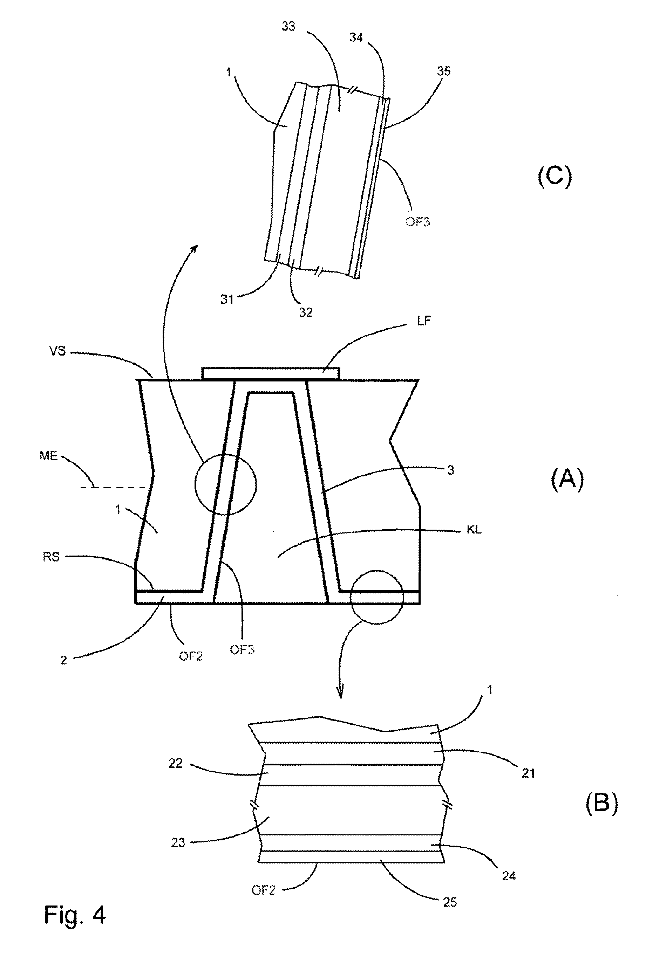

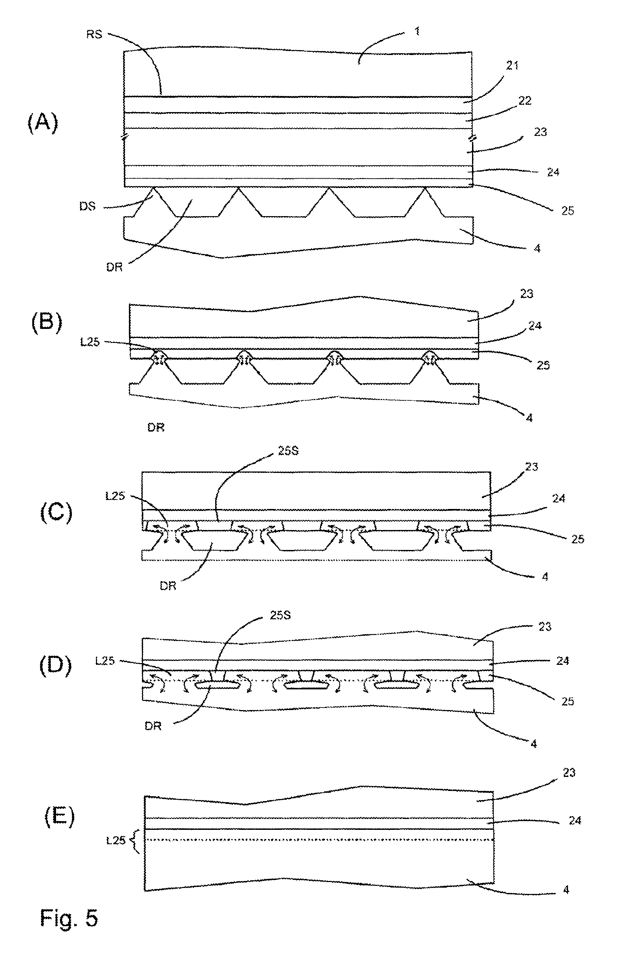

Die Erfindung sieht einen veränderten Aufbau der Rückseitenmetallisierung vor, welcher anhand der Fig. 4 und 5 an einem bevorzugten Ausführungsbeispiel näher erläutert ist. Fig. 4 (A) zeigt dabei nochmals ohne Details den Aufbau eines durch eine Rückseitenmetallisierung 2 rückseitig beschichteten Substrats, wobei sich diese Rückseitenmetallisierung entlang von Seitenwänden von Durchkontaktierungen als Metallisierungsschicht 3 fortsetzt bis zu Leiterflächen LF auf der Vorderseite VS des Substrats. Ein vergrößerter Ausschnitt aus der Rückseitenmetallisierung 2 ist in Fig. 4 (B), ein vergrößerter Ausschnitt aus der Metallisierungsschicht 3 entlang der Seitenwände der Durchkontaktierungen ist in Fig. 4 (C) dargestellt.

Die Rückseitenmetallisierung 2 zeigt in Übereinstimmung mit gebräuchlichen Vorgehensweisen auf der Rückseite RS des Substrats 1 eine Haftvermittlerschicht 21, welche beispielsweise aus Germanium bestehen kann. Auf dieser ist eine metallische Start-Schicht 22 vorzugsweise aus Au aufgebracht, auf welcher wiederum eine erste Au-Schicht 23 abgeschieden ist. Die erste Au-Schicht 23 wird vorzugsweise galvanisch abgeschieden und hat eine Schichtdicke von wenigstens 2000 nm, typischerweise ca. 3.500 nm. Die relativen Schichtdicken in Fig. 4 sind insbesondere hinsichtlich dieser ersten Au-Schicht 23 nicht als maßstäblich zu betrachten. Bei der Au-Schicht 23 sind als Zeichen dafür Unterbrechungen der seitlichen Schnittkanten mit eingezeichnet.

Auf die Au-Schicht 23 wird als wesentliches Element der Erfindung eine nachfolgend auch als Barrierenschicht 24 bezeichnete Zwischenschicht abgeschieden. Als letzte Schicht der Schichtenfolge wird eine zweite Au-Schicht 25 abgeschieden, welche die dem Lot-Preform 4 zuweisende Au-Oberfläche bildet.

Die Dicke der Barrierenschicht 24 beträgt an der Rückseite des Substrats vorteilhafterweise wenigstens 100 nm, insbesondere wenigstens 150 nm, vorzugsweise wenigstens 200 nm. Die Schichtdicke der zweiten Au-Schicht 25 beträgt vorteilhafterweise maximal 160 nm, insbesondere maximal 120 nm, vorzugsweise maximal 90 nm.

Die Barrierenschicht 24 besteht aus einem Material, welches im Temperaturbereich des Lötprozesses, d. h. bei ca. 280°C bis 300°C praktisch keine Löslichkeit mit Au und insbesondere mit Sn bzw. einer flüssigen Au-Sn-Phase mit hypereutektischem Goldanteil besitzt und dadurch eine Diffusion von in der zweiten Au-Schicht 25 sich ausbreitendem Sn durch die Barrierenschicht 24 in die erste Au-Schicht 23 im wesentlichen verhindert. Insbesondere wird eine Ausweitung der in der zweiten Au-Schicht entstehenden flüssigen AuSn-Phase in die erste Au-Schicht vermieden.

Vorzugsweise wird als Material für die Barrierenschicht Ti benutzt. Die Barrierenschicht verhindert ein Diffundieren von Sn aus der flüssigen Au-Sn-Phase, welche sich in der zweiten Au-Schicht 25 nach Aufschmelzen des Lot-Preforms bildet, in die erste Au-Schicht 23. Hierdurch wird zuverlässig die Bildung spröder Au-Sn-Phasen in der Nähe der Substratrückseite RS vermieden. Auch in dem Übergangsbereich der zweiten Au-Schicht 25 und des Lot-Preforms 4 ist die Bildung spröder Phasen verringert, da mit der dünnen zweiten Au-Schicht 25 nur eine relativ geringe Menge an Gold für die Bildung einer Legierung mit hypereutektischem Au-Anteil zur Verfügung steht und bei der Diffusion von Au aus der zweiten Au-Schicht 25 in das Au-Sn-Lot und umgekehrt sich eine Legierung mit nur geringem Au-Überschuss gegenüber dem eutektischen Legierungsverhältnis ergibt.

Die Barrierenschicht 24 verhindert vorteilhafterweise zusätzlich die Diffusion von Verunreinigungen aus der ersten Au-Schicht 23 an die Au-Oberfläche der Rückseitenmetallisierung. Dies ist insbesondere von Bedeutung bei der gebräuchlichen Verwendung von Ge in der Haftvermittlerschicht auf der Substratoberfläche, da Ge bereits bei relativ niedrigen Temperaturen eine starke Diffusion durch Au, insbesondere auch durch die dicke erste Au-Schicht zeigt und an der dem Substrat abgewandten Au-Oberfläche leicht oxidiert und die Benetzbarkeit herabsetzt. Da nicht benetzende Oberflächenbereiche NB der Au-Oberfläche der Rückseitenmetallisierung auf Verunreinigungen an der Au-Oberfläche zurückgeführt werden, verhindert die Barrierenschicht somit nicht nur die Fehlersituationen nach Fig. 3 (C), sondern auch solche nach Fig. 3 (B) wirksam auf einfache Weise.

Die zweite Au-Schicht 25 wird vorteilhafterweise durch einen Sputterprozess abgeschieden, durch welche eine besonders reine Schichtzusammensetzung und insbesondere auch eine besonders verunreinigungsarme Au-Oberfläche der Rückseitenmetallisierung erreicht werden kann. Die Wirkung der Barrierenschicht 24 als Barriere gegen die Diffusion von Verunreinigungen aus der ersten Au-Schicht 23 an die Au-Oberfläche der zweiten Au-Schicht 25 bewahrt diese günstigen Oberflächeneigenschaften der Au-Oberfläche der Rückseitenmetallisierung.

Erfindungsgemäß ist vorgesehen, das Material der Barrierenschicht 24 auch zur Verminderung von Fehlersituationen nach Fig. 3 (A) zu verwenden, indem gezielt die Diffusion von Material aus der Barrierenschicht an die Au-Oberfläche der Metallisierung 3 an den Seitenwänden der Durchkontaktierungen gefördert wird, um durch an die an die Au-Oberfläche gelangendes Material aus der Barrierenschicht an der Au-Oberfläche die Benetzungsfähigkeit mit Au-Sn-Lot gegenüber einer reinen Au-Oberfläche herabzusetzen. Als Material der Barrierenschicht ist hierfür besonders vorteilhaft Ti geeignet, welches bei Erreichen der Au-Oberfläche aufgrund einer stark negativen Bildungsenthalpie der Oxidation schnell zu Titanoxid oxidiert. Die Herabsetzung der Benetzungsfähigkeit durch oxidiertes Ti ist aus dem eingangs genannten Stand der Technik bekannt, bei welchem die Au-Oberfläche der Rückseitenmetallisierung in den Kontaktlöchern KL gezielt mit einer zusätzlichen Ti-Schicht versehen wird, welche oxidiert wird. Während bei diesem Stand der Technik der Einsatz einer zusätzlichen photolitographischen Maske erforderlich ist, wird bei der vorliegenden Erfindung eine schlecht benetzende Oberfläche in den Kontaktlöchern durch Diffusion von Material, insbesondere Ti, aus der Barrierenschicht der auch in den Kontaktlöchern mit der vollständigen Schichtenfolge abgeschiedenen Rückseitenmetallisierung erreicht, so dass keine zusätzliche Maskierung und Ätzung erforderlich ist.

Die Benetzbarkeit der Oberfläche OF2 der zweiten Au-Schicht 35 an der planen Rückseite des Substrats bleibt ausreichend erhalten, da durch die wesentlich größere Schichtdicke wenig Material aus der Zwischenschicht an diese Oberflächenbereiche gelangt. Lokale Störungen der Benetzbarkeit an der Oberfläche OF2 sind vernachlässigbar, da durch die direkte Anlage des Lot-Preforms 4 an der Oberfläche OF2 hinreichend Verbindungen geschaffen und Oberflächenbereiche von OF2 auch durch Hinterfließen in die Legierungsschicht L2 integrierbar sind.

Vorteilhafterweise wird beim Abscheiden der Rückseitenmetallisierung die zweite Au-Schicht anisotrop mit in der Metallisierungsschicht 3 an den Seitenwänden der Kontaktlöcher im Mittel wesentlich geringerer Schichtdicke als im Bereich der Rückseitenmetallisierung 2 abgeschieden. In Fig. 4 (C) ist ein Ausschnitt aus der Metallisierungsschicht 3 an den Seitenwänden der Kontaktlöcher detaillierter dargestellt, wobei wiederum auf der Halbleiter-Oberfläche des Substrats an den Seitenwänden der durch das Substrat durchgehend hergestellten Öffnungen eine Haftvermittlerschicht 31, auf dieser eine metallische Startschicht 32, auf dieser eine vorzugsweise galvanisch abgeschiedene erste Au-Schicht 33, danach eine Barrierenschicht 34 und als letzte Schicht eine zweite Au-Schicht 35 abgeschieden werden. Die Schichten 31, 32 und 34 werden typischerweise gleichfalls anisotrop, insbesondere durch Sputtern abgeschieden und sind daher auch dünner als die entsprechenden Schichten 21, 22 und 24 der Rückseitenmetallisierung 2. Die Schichtdicke der zweiten Au-Schicht 35 in den Kontaktlöchern kann bei Abscheidung mittels eines Sputterprozesses durch die Prozessparameter so eingestellt werden, dass sie an dem der Vorderseite VS nahen Fußbereich der Durchgangslöcher weniger als ein Drittel der Schichtdicke der zweiten Au-Schicht 25 in der Rückseitenmetallisierung 2 beträgt. Die Schichtdicke der zweiten Au-Schicht 35 nimmt bei durch Sputtern abgeschiedener zweiter Au-Schicht 35 an den Seitenwänden der Durchgangslöcher typischerweise von der Rückseite RS in Richtung der Vorderseite VS bzw. der Leiterflächen LF kontinuierlich ab. Vorteilhafterweise beträgt die Schichtdicke der zweiten Au-Schicht 35 bei einer Mittelebene ME zwischen Vorderseite VS und Rückseite RS des Substrats 1 nicht mehr als 50% der Schichtdicke der zweiten Au-Schicht 25 in der Rückseitenmetallisierung 2 auf der Rückseite des Substrats 1, vorzugsweise nicht mehr als 50 nm. Durch die geringe Schichtdicke der zweiten Au-Schicht 35 wird zum einen bei Anwendung erhöhter Temperatur auf das metallisierte Substrat eine Diffusion von Ti aus der Barrierenschicht 34 an die Au-Oberfläche OF3 der zweiten Au-Schicht 35 begünstigt, zum anderen wird durch die geringe Schichtdicke der zweiten Au-Schicht 35 an den Seitenwänden der Durchkontaktierungen die Ausbreitung von Sn aus dem an der Verbindung der Schichten 25 und 35 vorliegenden Au-Sn-Lot erheblich vermindert. Die Oberfläche der die Anlagefläche für das Lot-Preform 4 bildenden zweiten Au-Schicht ist mit OF2 bezeichnet.

Die zweite Au-Schicht 35 im Bereich der Metallisierung 3 an den Seitenwänden der Kontaktlöcher weist in der der Vorderseite VS des Substrats 1 zugewandten Hälfte vorteilhafterweise eine mittlere Schichtdicke von maximal 40 nm auf. Die zweite Au-Schicht 35 besitzt bei einer mittig zwischen Vorderseite VS und Rückseite RS liegenden Mittelebene ME vorteilhafterweise eine Schichtdicke von maximal 50 nm.

Fig. 5 zeigt schematisch einen möglichen anfänglichen Ablauf eines Lötprozesses. Dargestellt ist ein Ausschnitt aus der Rückseitenmetallisierung 2 und eine Oberfläche des Lot-Preforms 4. Die Oberfläche des Lot-Preforms 4 ist typischerweise wesentlich rauher als die Au-Oberfläche 25 der Rückseitenmetallisierung, was durch die Spitzen DS an der Oberfläche des Lot-Preforms angedeutet ist, an welchen sich die Au-Oberfläche der Schicht 25 der Rückseiten-metallisierung anfänglich abstützt. In der Ausgangssituation nach Fig. 5 (A) tritt noch keine Verflüssigung des Au-Sn-Lots auf und die Au-Oberfläche der Schicht 25 liegt überwiegend zwischen den punktuellen Anlageflächen der Spitzen RS frei und ist durch Freiräume DR von der Oberfläche des Lot-Preforms 4 um ein geringes Maß beabstandet.

In Fig. 5 (B) ist dargestellt, dass die mit der Au-Oberfläche der zweiten Au-Schicht 25 der Rückseitenmetallisierung 2 punktuell in Verbindung stehenden Spitzen RS des Lot-Preforms schmelzen. Dabei geht Au aus der Schicht 25 mit dem geschmolzenen Au-Sn-Lot eine flüssige Phase ein und gelöstes Au diffundiert aus der Schicht 25 in das Au-Sn-Lot des Preforms und im Gegenzug diffundiert Sn aus dem Au-Sn-Lot in die Schicht 25. Die dabei gebildete Au-Sn-Legierung mit einem hypereutektischem Anteil von Au ist mit L25 bezeichnet. Durch Abschmelzen der Spitzen RS des Lot-Preforms verringert sich der Abstand zwischen Rückseitenmetallisierung und dem Lot-Preform 4.

Bei weiterem Fortschreiten des Lötprozesses erfolgt weiter ein Lösen der Metalle der zweiten Au-Schicht 25 und des Lot-Preforms ineinander unter Bildung der Au-Sn-Legierung L25 als flüssige Phase mit einem gegenüber dem reinen Au-Sn-Lot leicht erhöhten Au-Anteil. Da ein Ausbreiten von Sn über die Schicht 25 hinaus durch die Barrierenschicht 24 verhindert ist, erfolgt ein Ausbreiten der flüssigen Legierungsphase L25 senkrecht zur Sichtebene nur bis zur Schichtgrenze zur Schicht 24 und in der Schichtebene seitlich. Durch die gute Benetzbarkeit der Au-Oberfläche der zweiten Au-Schicht 25 wird die schnelle seitliche Ausbreitung der flüssigen Legierungsphase L25 stark begünstigt. In dem Zwischenschritt nach Fig. 5 (C) sind noch unverflüssigte Stege 25S der zweiten Au-Schicht 25 dargestellt.

Mit weiter fortschreitendem Lötvorgang werden die verbleibenden Stege 25S der zweiten Au-Schicht 25 schnell schmäler, wie in Fig. 5 (D) dargestellt. Gleichzeitig verschwinden zusehends die Zwischenräume DR durch den mit geschwungenen Pfeilen symbolisierten Austausch von Au und Sn zwischen der Schicht 25 und dem Lot-Preform 4, bis im Idealfall nach Fig. 5 (E) die Au-Schicht 25 vollflächig aufgelöst ist und sich eine durchgehende Legierungsschicht L25 als Übergang von der Barrierenschicht 24 zu dem Lot des Lot-Preforms 4 ausgebildet hat.

Vorteilhafterweise kann der Lötprozess selbst als Behandlung des Substrats bei erhöhter Temperatur zur Diffusion von Ti aus der Barrierenschicht 34 der Metallisierung 3 zu der Oberfläche OF3 an den Seitenwänden der Durchkontaktierungen genutzt werden. Der Lötprozess findet bei ca. 280°C bis 300°C statt. Die dabei bewirkte Diffusion von Ti durch die zweite Au-Schicht 35 tritt prinzipiell in entsprechender Weise auch bei der zweiten Au-Schicht 25 in Erscheinung, wobei dort in dem in Fig. 5 dargestellten Prozess durch die gegenüber der Schicht 35 wesentlich größere Schichtdicke der Schicht 25 die Diffusion bis zur Au-Oberfläche OF3 der Schicht 25 aber stark verzögert ist. Ferner nimmt die Au-Oberfläche OF2 der Schicht 25 bereits zu Beginn des Lötprozesses mit zunehmender Bildung von Legierungsbereichen L25 ab. Eventuell an der Oberfläche OF2 der zweiten Au-Schicht 25 durch Diffusion von Ti aus der Zwischenschicht 24 vorliegende punktuelle Bereiche mit verminderter Benetzbarkeit werden von der flüssigen AuSn-Phase hinterflossen und vollständig in die Legierungsschicht L25 integriert. Durch die Dicken der zweiten Au-Schicht 25, 35 und die Temperaturführung beim Lötprozess und/oder bei einem gegebenenfalls vorgeschalteten Diffusions- und/oder Oxidationsprozess können die unterschiedlichen Benetzbarkeiten der Oberflächen OF2 und OF3 gezielt eingestellt werden.

Durch die Barrierewirkung der Schicht 24 gegen das Ausbreiten der flüssigen AuSn-Phase in die zweite Au-Schicht 23 kann darüber hinaus ohne die Gefahr der Bildung spröder Phasen die Temperatur und/oder die Behandlungsdauer beim Lötprozess so hoch gewählt werden, dass der Anteil von Fehlersituationen der in Fig. 3 (B) dargestellten Art vernachlässigbar gering bleibt. Die Unempfindlichkeit der Metallisierung mit der Barrierenschicht gegen höhere Löttemperaturen und/oder gegen längere Lötzeiten eröffnet vorteilhafterweise auch mehr Freiheiten bei den Parametern des Lötprozesses, so dass beispielsweise in einem gemeinsamen Bauteilgehäuse auch Komponenten über andere Lötverbindungen mit höheren Löttemperaturen und/oder längeren Lötdauern in einem Lötprozess mit der AuSn/Au-Lötverbindung einlötbar sind.

## Patentansprüche

1. Verfahren zur Herstellung eines elektronischen Bauteils mit wenigstens einem im Betrieb eine Verlustwärmequelle bildenden Halbleiter-Bauelement auf einer Vorderseite eines Halbleiter-Substrats (1), wobei die dem Bauelement abgewandte Rückseite (RS) mit einer Rückseiten-Metallisierung (2) versehen und unter Verwendung einer Sn enthaltenden Lotschicht (4) in einem Lötprozess wärmeleitend mit einer Wärmesenke (6) verbunden wird, und wobei auch an Durchgangs-Öffnungen (KL) zwischen Vorderseite und Rückseite durch das Substrat eine Metallisierung (3) abgeschieden wird, wobei für die Rückseiten-Metallisierung (2) und die Metallisierung (3) der Durchgangsöffnungen (KL) nacheinander eine erste Au-Schicht (23, 33), eine Zwischenschicht (24, 34) aus einem von Au und Sn verschiedenen Material und eine zweite Au-Schicht (25, 35) abgeschieden werden und wobei für die Zwischenschicht ein Material gewählt wird, welches eine Diffusionsbarriere für eine flüssige AuSn-Phase bildet und eine Ausbreitung einer beim Lötprozess an der Stelle der zweiten Au-Schicht gebildeten flüssigen AuSn-Phase in die erste Au-Schicht verhindert, **dadurch gekennzeichnet, dass** an den Seitenwänden der Durchgangs-Öffnungen die zweite Au-Schicht (35) mit geringerer Dicke abgeschieden und an der Oberfläche (OF3) die Benetzbarkeit für Material der Lotschicht vermindert wird gegenüber Dicke und Benetzbarkeit der zweiten Au-Schicht (25) an der Rückseite des Substrats, indem Material aus der Zwischenschicht (34) durch die zweite Au-Schicht (35) als die Benetzbarkeit verminderndes Material bei erhöhter Temperatur zur Oberfläche (OF3) der zweiten Au-Schicht (35) an den Seitenwänden der Öffnungen diffundiert wird.

2. Verfahren nach Anspruch 1, **dadurch gekennzeichnet, dass** aus der Zwischenschicht (34) an die Oberfläche (OF3) der zweiten Au-Schicht (35) diffundiertes Material dort oxidiert wird.

3. Verfahren nach einem der Ansprüche 1 bis2, **dadurch gekennzeichnet, dass** für die Zwischenschicht (24) zumindest überwiegend eines oder mehrere der Materialien von Ti, W, Mo, Ta oder chemischen Verbindungen mit diesen, vorzugsweise zumindest überwiegend Ti gewählt wird.

4. Verfahren nach einem der Ansprüche 1 bis 3, **dadurch gekennzeichnet, dass** die Zwischenschicht in Form wenigstens zweier Teilschichten abgeschieden wird.

5. Verfahren nach Anspruch 4, **dadurch gekennzeichnet, dass** für eine erste Teilschicht TiN und für eine zwischen der ersten Teilschicht und der zweiten Goldschicht abgeschiedene zweite Teilschicht Ti als zumindest überwiegendes Material gewählt wird.

6. Verfahren nach einem der Ansprüche 1 bis 5, **dadurch gekennzeichnet, dass** die Zwischenschicht (24) auf der Substratrückseite mit einer Schichtdicke von wenigstens 100 nm, insbesondere wenigstens 150 nm, vorzugsweise wenigstens 200 nm abgeschieden wird.

7. Verfahren nach einem der Ansprüche 1 bis 6, **dadurch gekennzeichnet, dass** die zweite Au-Schicht (25) mit geringerer Schichtdicke als die erste Au-Schicht (23) abgeschieden wird

8. Verfahren nach einem der Ansprüche 1 bis 7, **dadurch gekennzeichnet, dass** die zweite Au-Schicht mit einer Schichtdicke von weniger als 160 nm, insbesondere weniger als 120 nm, vorzugsweise weniger als 90 nm abgeschieden wird.

9. Verfahren nach einem der Ansprüche 1 bis 8, **dadurch gekennzeichnet, dass** die zweite Au-Schicht (25, 35) in einem Sputterprozess abgeschieden wird.

10. Verfahren nach einem der Ansprüche 1 bis 9, **dadurch gekennzeichnet, dass** die erste Au-Schicht (23) mit einer Schichtdicke von wenigstens 2000nm abgeschieden wird.

11. Verfahren nach einem der Ansprüche 1 bis 10, **dadurch gekennzeichnet, dass** die zweite Au-Schicht (35) an den Seitenwänden der Öffnungen bei einer Mittelebene des Substrats nicht mehr als 50 % der Schichtdicke der zweiten Au-Schicht (25) an der Rückseite des Substrats, vorzugsweise nicht mehr als 50 nm beträgt.

12. Verfahren nach einem der Ansprüche 1 bis 11, **dadurch gekennzeichnet, dass** die Schichtdicke der zweiten Au-Schicht (35) an den Seitenwänden der Öffnungen (KL) mit einer Schichtdicke abgeschieden wird, die in der der Vorderseite zugewandten Hälfte der Durchgangs-Öffnungen im Mittel geringer ist als 40 nm.

13. Verfahren nach einem der Ansprüche 1 bis 12, **dadurch gekennzeichnet, dass** das Substrat mit der Rückseiten-Metallisierung vor oder vorzugsweise bei dem Lötprozess auf eine Temperatur von wenigstens 280°C erwärmt wird.

14. Elektronisches Bauteil, hergestellt in einem Verfahren nach einem der Ansprüche 1 bis 13, mit einem durch eine Lötverbindung mit einer Wärmesenke (6) wärmeleitend verbundenen und wenigstens ein Halbleiter-Bauelement als Verlustwärmequelle enthaltenden und metallisierte Durchgangs-Öffnungen (KL) aufweisenden Halbleiter-Substrat (1) , mit einer ersten Au-Schicht (23) auf der der Wärmesenke zuweisenden Rückseite (RS) des Substrats, einer dem Substrat abgewandt auf die erste Au-Schicht folgenden Zwischenschicht (24) und einer der ersten Au-Schicht abgewandt auf die Zwischenschicht folgenden Au-Sn-Legierungsschicht (L2), wobei die Zwischenschicht (24) aus einem von Au und Sn verschiedenen Material besteht und an den Seitenwänden der Durchgangs-Öffnungen als Metallisierung (3) die Schichtenfolge der Rückseitenmetallisierung zumindest mit der ersten Au-Schicht (33) der Zwischenschicht (34) und der zweiten Au-Schicht (35) abgeschieden ist und die Oberfläche der an den Seitenwänden der Durchgangskontaktierungen abgeschiedenen zweiten Au-Schicht (35) eine reduzierte Benetzbarkeit für Material der Lötverbindung durch Material aus der Zwischenschicht (34), welches mittels Diffusion bei erhöhter Temperatur aus der Zwischenschicht (34) durch die zweite Au-Schicht (35) an deren Oberfläche diffundiert ist, aufweist.

15. Elektronisches Bauteil nach Anspruch 14, **dadurch gekennzeichnet, dass** die Zwischenschicht eines oder mehrere der Materialien von Ti, W, Mo, Ta, insbesondere zumindest überwiegend Ti enthält.

16. Elektronisches Bauteil nach Anspruch 14 oder 15, **dadurch gekennzeichnet, dass** die Zwischenschicht durch wenigstens zwei Teilschichten gebildet ist.

17. Elektronisches Bauteil nach Anspruch 16, **dadurch gekennzeichnet, dass** eine erste Teilschicht zumindest überwiegend, vorzugsweise vollständig aus TiN besteht.

18. Elektronisches Bauteil nach einem der Ansprüche 14 bis 17, **dadurch gekennzeichnet, dass** die Schichtdicke der zweiten Au-Schicht (35) an den Seitenwänden der Öffnungen bei einer Mittelebene des Substrats nicht mehr als 50 % der Schichtdicke der der zweiten Au-Schicht (25) an der Substratrückseite, insbesondere nicht mehr als 50 nm beträgt.

19. Elektronisches Bauteil nach einem der Ansprüche 14 bis 18, **dadurch gekennzeichnet, dass** die Schichtdicke der ersten Au-Schicht (23) größer ist als die Schichtdicke der Zwischenschicht (24).

20. Elektronisches Bauteil nach einem der Ansprüche 14 bis 18, **dadurch gekennzeichnet, dass** die Schichtdicke der ersten Au-Schicht (23) auf der Substrat-Rückseite mehr als 2000 nm beträgt.

21. Elektronisches Bauteil nach einem der Ansprüche 14 bis 20, **dadurch gekennzeichnet, dass** die Schichtdicke der Zwischenschicht (24) auf der Substrat-Rückseite wenigstens 100 nm, insbesondere wenigstens 150 nm, vorzugsweise wenigstens 200 nm beträgt.

22. Elektronisches Bauteil nach einem der Ansprüche 14 bis 21, **dadurch gekennzeichnet, dass** die Legierungsschicht mehr als 80 % Au enthält.

23. Elektronisches Bauteil nach einem der Ansprüche 14 bis 22, **dadurch gekennzeichnet, dass** die Schichtdicke der zweiten Au-Schicht (35) geringer ist die Dicke der Zwischenschicht.

## Claims

1. Method for producing an electronic component having at least one semiconductor component, forming a waste heat source during operation, on a front side of a semiconductor substrate (1), wherein the back side (RS) which faces away from the component is provided with a back-side metallization (2) and is connected in a thermally conductive manner to a heat sink (6) in a soldering process using an Sn-containing solder layer (4), and wherein a metallization (3) is also deposited on through-openings (KL) between the front side and the back side through the substrate, wherein a first Au layer (23, 33), an intermediate layer (24, 34) composed of a material different from Au and Sn and a second Au layer (25, 35) are deposited in succession for the back-side metallization (2) and the metallization (3) of the through-openings (KL), and wherein a material which forms a diffusion barrier for a liquid AuSn phase and prevents propagation of a liquid AuSn phase formed during the soldering process at the site of the second Au layer into the first Au layer is selected for the intermediate layer, **characterized in that** the second Au layer (35) is deposited with a lesser thickness on the side walls of the through-openings and the wettability for material of the solder layer is reduced at the surface (OF3) as compared with the thickness and wettability of the second Au layer (25) on the back side of the substrate, **in that** material from the intermediate layer (34) is diffused, at an elevated temperature, through the second Au layer (35), as a material reducing the wettability, towards the surface (OF3) of the second Au layer (35) on the side walls of the openings.

2. Method according to Claim 1, **characterized in that** material which diffuses out of the intermediate layer (34) onto the surface (OF3) of the second Au layer (35) is oxidized there.

3. Method according to either of Claims 1 and 2, **characterized in that** at least predominantly one or more of the materials Ti, W, Mo, Ta or chemical compounds comprising these, preferably at least predominantly Ti, are selected for the intermediate layer (24).

4. Method according to one of Claims 1 to 3, **characterized in that** the intermediate layer is deposited in the form of at least two partial layers.

5. Method according to Claim 4, **characterized in that** TiN is selected for a first partial layer and Ti is selected as an at least predominant material for a second partial layer deposited between the first partial layer and the second gold layer.

6. Method according to one of Claims 1 to 5, **characterized in that** the intermediate layer (24) is deposited on the substrate back side with a layer thickness of at least 100 nm, in particular at least 150 nm, preferably at least 200 nm.

7. Method according to one of Claims 1 to 6, **characterized in that** the second Au layer (25) is deposited with a lesser layer thickness than the first Au layer (23).

8. Method according to one of Claims 1 to 7, **characterized in that** the second Au layer is deposited with a layer thickness of less than 160 nm, in particular less than 120 nm, preferably less than 90 nm.

9. Method according to one of Claims 1 to 8, **characterized in that** the second Au layer (25, 35) is deposited using a sputtering process.

10. Method according to one of Claims 1 to 9, **characterized in that** the first Au layer (23) is deposited with a layer thickness of at least 2000 nm.

11. Method according to one of Claims 1 to 10, **characterized in that** the second Au layer (35) amounts to not more than 50% of the layer thickness of the second Au layer (25) on the back side of the substrate, preferably not more than 50 nm, on the side walls of the openings at a centre plane of the substrate.

12. Method according to one of Claims 1 to 11, **characterized in that** the layer thickness of the second Au layer (35) is deposited on the side walls of the openings (KL) with a layer thickness which is on average less than 40 nm in the half of the through-openings which faces towards the front side.

13. Method according to one of Claims 1 to 12, **characterized in that** the substrate with the back-side metallization is heated to a temperature of at least 280°C before or preferably during the soldering process.

14. Electronic component, produced using a method according to one of Claims 1 to 13, having a semiconductor substrate (1) which is connected in a thermally conductive manner to a heat sink (6) by a soldered joint, contains at least one semiconductor component as a waste heat source and has metallized through-openings (KL), having a first Au layer (23) on the back side (RS) of the substrate facing towards the heat sink, an intermediate layer (24) which follows the first Au layer facing away from the substrate, and an Au-Sn alloy layer (L2) which follows the intermediate layer facing away from the first Au layer, wherein the intermediate layer (24) consists of a material different from Au and Sn, and the layer sequence of the back-side metallization at least with the first Au layer (33), the intermediate layer (34) and the second Au layer (35) is deposited on the side walls of the through-openings as a metallization (3), and the surface of the second Au layer (35) deposited on the side walls of the through-connections has a reduced wettability for material of the soldered joint by virtue of material from the intermediate layer (34), which is diffused at an elevated temperature by means of diffusion out of the intermediate layer (34) through the second Au layer (35) onto the surface thereof.

15. Electronic component according to Claim 14, **characterized in that** the intermediate layer contains one or more of the materials Ti, W, Mo, Ta, in particular at least predominantly Ti.

16. Electronic component according to Claim 14 or 15, **characterized in that** the intermediate layer is formed by at least two partial layers.

17. Electronic component according to Claim 16, **characterized in that** a first partial layer consists at least predominantly, preferably completely, of TiN.

18. Electronic component according to one of Claims 14 to 17, **characterized in that** the layer thickness of the second Au layer (35) amounts to not more than 50% of the layer thickness of the second Au layer (25) on the back side of the substrate, in particular not more than 50 nm, on the side walls of the openings at a centre plane of the substrate.

19. Electronic component according to one of Claims 14 to 18, **characterized in that** the layer thickness of the first Au layer (23) is greater than the layer thickness of the intermediate layer (24).

20. Electronic component according to one of Claims 14 to 18, **characterized in that** the layer thickness of the first Au layer (23) on the back side of the substrate is more than 2000 nm.

21. Electronic component according to one of Claims 14 to 20, **characterized in that** the layer thickness of the intermediate layer (24) on the back side of the substrate is at least 100 nm, in particular at least 150 nm, preferably at least 200 nm.

22. Electronic component according to one of Claims 14 to 21, **characterized in that** the alloy layer contains more than 80% Au.

23. Electronic component according to one of Claims 14 to 22, **characterized in that** the layer thickness of the second Au layer (35) is less than the thickness of the intermediate layer.

## Revendications

1. Procédé de production d'un composant électronique avec au moins un élément de circuit semi-conducteur formant en fonctionnement une source de déperdition de chaleur sur une face avant d'un substrat semi-conducteur (1), dans lequel la face arrière (RS) située à l'opposé de l'élément de circuit est munie d'une métallisation de face arrière (2) et est reliée en conduction de chaleur, par une opération de brasage, à un puits de chaleur (6) en utilisant une couche de brasage (4) contenant du Sn, et dans lequel une métallisation (3) est également déposée sur des ouvertures de passage (KL) entre la face avant et la face arrière à travers le substrat, dans lequel, pour la métallisation de face arrière (2) et la métallisation (3) des ouvertures de passage (KL), on dépose l'une après l'autre une première couche de Au (23, 33), une couche intermédiaire (24, 34) en un matériau différent de Au et de Sn et une deuxième couche de Au (25, 35), et dans lequel on choisit pour la couche intermédiaire un matériau qui forme une barrière de diffusion pour une phase liquide Au-Sn et empêche une propagation dans la première couche de Au d'une phase liquide Au-Sn formée lors de l'opération de brasage à l'endroit de la deuxième couche de Au, **caractérisé en ce que** l'on dépose la deuxième couche de Au (35) avec une épaisseur moindre sur les faces latérales des ouvertures de passage et on diminue sur la surface (OF3) la mouillabilité pour le matériau de la couche de brasage par rapport à l'épaisseur et à la mouillabilité de la deuxième couche de Au (25) sur la face arrière du substrat, en faisant diffuser du matériau de la couche intermédiaire (34) à travers la deuxième couche de Au (35) comme matériau diminuant la mouillabilité à plus haute température vers la surface (OF3) de la deuxième couche de Au (35) sur les parois latérales des ouvertures.

2. Procédé selon la revendication 1, **caractérisé en ce que** le matériau diffusé de la couche intermédiaire (34) à la surface (OF3) de la deuxième couche de Au (35) y est oxydé.

3. Procédé selon l'une quelconque des revendications 1 à 2, **caractérisé en ce que** l'on choisit pour la couche intermédiaire (24) au moins principalement un ou plusieurs des matériaux de Ti, W, Mo, Ta ou de composés chimiques avec ceux-ci, de préférence au moins principalement Ti.

4. Procédé selon l'une quelconque des revendications 1 à 3, **caractérisé en ce que** l'on dépose la couche intermédiaire sous la forme d'au moins deux couches partielles.

5. Procédé selon la revendication 4, **caractérisé en ce que** l'on choisit comme matériau au moins principal TiN pour une première couche partielle et Ti pour une deuxième couche partielle déposée entre la première couche partielle et la deuxième couche d'or.

6. Procédé selon l'une quelconque des revendications 1 à 5, **caractérisé en ce que** l'on dépose la couche intermédiaire (24) sur la face arrière du substrat avec une épaisseur de couche d'au moins 100 nm, en particulier au moins 150 nm, et de préférence au moins 200 nm.

7. Procédé selon l'une quelconque des revendications 1 à 6, **caractérisé en ce que** l'on dépose la deuxième couche de Au (25) avec une épaisseur de couche plus faible que la première couche de Au (23).

8. Procédé selon l'une quelconque des revendications 1 à 7, **caractérisé en ce que** l'on dépose la deuxième couche de Au avec une épaisseur de couche de moins de 160 nm, en particulier moins de 120 nm, et préférence moins de 90 nm.

9. Procédé selon l'une quelconque des revendications 1 à 8, **caractérisé en ce que** l'on dépose la deuxième couche de Au (25, 35) par un procédé de pulvérisation cathodique.

10. Procédé selon l'une quelconque des revendications 1 à 9, **caractérisé en ce que** l'on dépose la première couche de Au (23) avec une épaisseur de couche d'au moins 2000 nm.

11. Procédé selon l'une quelconque des revendications 1 à 10, **caractérisé en ce que** la deuxième couche de Au (35) sur les parois latérales des ouvertures, dans un plan moyen du substrat, ne vaut pas plus de 50 % de l'épaisseur de couche de la deuxième couche de Au (25) sur la face arrière du substrat, de préférence pas plus de 50 nm.

12. Procédé selon l'une quelconque des revendications 1 à 11, **caractérisé en ce que** l'on dépose l'épaisseur de couche de la deuxième couche de Au (35) sur les parois latérales des ouvertures (KL) avec une épaisseur de couche, qui est en moyenne inférieure à 40 nm dans la moitié des ouvertures de passage tournée vers la face avant.

13. Procédé selon l'une quelconque des revendications 1 à 12, **caractérisé en ce que** l'on chauffe le substrat avec la métallisation de face arrière avant ou de préférence lors de l'opération de brasage à une température d'au moins 280°C.

14. Composant électronique, produit par un procédé selon l'une quelconque des revendications 1 à 13, comportant un substrat semi-conducteur (1) relié en conduction de chaleur par une liaison brasée à un puits de chaleur (6) et contenant au moins un élément de circuit semi-conducteur comme source de déperdition de chaleur et présentant des ouvertures de passage métallisées (KL), avec une première couche de Au (23) sur la face arrière (RS) du substrat tournée vers le puits de chaleur, une couche intermédiaire (24) suivant la première couche de Au à l'opposé du substrat et une couche d'alliage Au-Sn (L2) suivant la couche intermédiaire à l'opposé de la première couche de Au, dans lequel la couche intermédiaire (24) se compose d'un matériau différent de Au et Sn et la suite de couches de la métallisation de face arrière est déposée comme métallisation (3) sur les parois latérales des ouvertures de passage au moins avec la première couche de Au (33), la couche intermédiaire (34) et la deuxième couche de Au (35) et la surface de la deuxième couche de Au (35) déposée sur les parois latérales des contacts de passage présente une mouillabilité pour le matériau de la liaison brasée réduite par du matériau de la couche intermédiaire (34), qui a diffusé par diffusion à température accrue à partir de la couche intermédiaire (34) à travers la deuxième couche de Au (35) à la surface de celle-ci.

15. Composant électronique selon la revendication 14, **caractérisé en ce que** la couche intermédiaire contient un ou plusieurs des matériaux de Ti, W, Mo, Ta, en particulier au moins principalement Ti.

16. Composant électronique selon la revendication 14 ou 15, **caractérisé en ce que** la couche intermédiaire est formée par au moins deux couches partielles.

17. Composant électronique selon la revendication 16, **caractérisé en ce qu'**une première couché partielle se compose au moins principalement, de préférence entièrement, de TiN.

18. Composant électronique selon l'une quelconque des revendications 14 à 17, **caractérisé en ce que** l'épaisseur de couche de la deuxième couche de Au (35) sur les parois latérales des ouvertures, dans un plan moyen du substrat, ne vaut pas plus de 50 % de l'épaisseur de couche de la deuxième couche de Au (25) sur la face arrière du substrat, en particulier pas plus de 50 nm.

19. Composant électronique selon l'une quelconque des revendications 14 à 18, **caractérisé en ce que** l'épaisseur de couche de la première couche de Au (23) est plus grande que l'épaisseur de couche de la couche intermédiaire (24).

20. Composant électronique selon l'une quelconque des revendications 14 à 18, **caractérisé en ce que** l'épaisseur de couche de la première couche de Au (23) sur la face arrière du substrat vaut plus que 2000 nm.

21. Composant électronique selon l'une quelconque des revendications 14 à 20, **caractérisé en ce que** l'épaisseur de couche de la couche intermédiaire (24) sur la face arrière du substrat vaut au moins 100 nm, en particulier au moins 150 nm, de préférence au moins 200 nm.

22. Composant électronique selon l'une quelconque des revendications 14 à 21, **caractérisé en ce que** la couche d'alliage contient plus de 80 % de Au.

23. Composant électronique selon l'une quelconque des revendications 14 à 22, **caractérisé en ce que** l'épaisseur de couche de la deuxième couche de Au (35) est inférieure à l'épaisseur de la couche intermédiaire.
